# EUROPÄISCHE PATENTANMELDUNG

(11) **EP 1 622 190 A1**
(43) Veröffentlichungstag der Anmeldung: **01.02.2006**
(21) Anmeldenummer: 04018147.1
(22) Anmeldetag: 30.07.2004
(51) Int. Cl.: H01L 21/00

(54) **Ausrichtungsvorrichtung für einen Wafer und zugehöriges Verfahren**

(71) Anmelder: Innolas GmbH, 82152 Krailling (DE)
(72) Erfinder: Behr, Andreas, 86899 Landsberg (DE)
(74) Vertreter: Seitz, Ralf Hans Frank

(57) **Zusammenfassung**

Die vorliegende Erfindung betrifft eine Vorrichtung zum Ausrichten eines Wafers, die einen Drehteller (1) hat, der den Wafer trägt und der um seine Drehachse (M) zum Ausrichten des Wafers drehbar ist, wobei der Drehteller (1) derart ausgebildet ist, dass der Wafer auf dem Drehteller (1) nur mit seinem Rand oder Randbereich aufliegt, und ein zugehöriges Verfahren.

## Beschreibung

Die Erfindung betrifft eine Vorrichtung zum Ausrichten eines Wafers, die auch als Aligner bezeichnet wird, und ein zugehöriges Verfahren.

In der WO 02/079059 ist eine bekannte Ausrichtvorrichtung, auch Prealigner genannt, zum Ausrichten eines Wafers beschrieben, die einen Teller, auf dem der Wafer mit seinem Zentrum beim Ausrichten flächig aufliegt und der elektromotorisch zum Ausrichten des Wafers gedreht werden kann, und eine Detektionseinrichtung mit einer CCD-Kamera und einer zugehörigen Lichtquelle zum Detektieren einer Randkerbe bzw. Notch des Wafers hat.

Bei der bekannten Waferausrichtvorrichtung liegt der Wafer flächig auf dem Drehteller auf, wodurch die Oberfläche des Wafers aufgrund unerwünschter Verschmutzung schon durch gegenseitige Berührung oder z.B. Maschinenabrieb beeinträchtigt werden kann, was insbesondere in der Halbleiterfertigung hochintegrierter Schaltungen mit großen Wafern zu einer Minderung der Ausbeute funktionierender Schaltungen führen kann.

Aufgabe der Erfindung ist es deshalb, eine Ausrichtvorrichtung für einen Wafer anzugeben, die eine Beeinträchtigung der Wafer aufgrund Verschmutzung in der Ausrichtvorrichtung vermeidet.

Diese Aufgabe wird durch die Ausrichtvorrichtung nach Anspruch 1 bzw. durch das Verfahren nach Anspruch 13 gelöst. Die Vorrichtung der Erfindung zum Ausrichten eines Wafers, der eine Kerbe, Aussparung oder Markierung haben kann, hat demnach einen Drehteller, der den Wafer trägt und der um seine Mittenachse zum Ausrichten des Wafers drehbar ist, wobei der Wafer auf dem Drehteller nur mit seinem Rand aufliegt, wodurch eine Verschmutzung der Waferoberfläche, nämlich der Unterseite und auch der Oberseite des Wafers, vermieden wird. Die Vorrichtung der Erfindung ermöglicht somit eine erfolgreiche Bearbeitung, z.B. Markierung oder Ritzung, sowohl der Oberseite als auch der Unterseite des Wafers ohne störende Verunreinigungen der Waferoberfläche, wodurch die Ausbeute an z.B. funktionierenden Integrierten Schaltungen auf den bearbeiteten Wafern erhöht werden kann.

Bevorzugt hat die Ausrichtvorrichtung eine Einrichtung zum Halten des Wafers in einer Lage mit Abstand von dem Drehteller derart, dass sich der Drehteller ohne Wafer drehen kann. Die Halteeinrichtung kann dabei z.B. eine stationäre Ablage sein, auf der der Drehteller, der auch eine lineare Hubbewegung senkrecht zur Drehtellerebene ausführen kann, beim Absenken den Wafer ablegt. Die Halteeinrichtung ermöglicht, eine Drehung des Drehtellers relativ zum Wafer, um z.B. den Drehteller in eine bestimmte Position bringen zu können.

Bevorzugt hat die Ausrichtvorrichtung der Erfindung als Halteeinrichtung eine Hebeeinrichtung zum Abheben des Wafers von dem Drehteller, zum Halten des Wafers in einer Lage mit Abstand von dem Drehteller, damit sich der Drehteller ohne Wafer drehen kann, und zum Absenken des Wafers wieder auf den Drehteller.

Bevorzugt hat auch die Hebeeinrichtung oder die Halteeinrichtung geneigte oder konisch Auflagerflächen, auf denen ein Wafer nur mit seinem Rand oder mit seinem Randbereich aufliegt, wenn der Wafer von der Hebeeinrichtung hochgehoben, gehalten oder wieder abgesenkt wird, um Verschmutzungen der Waferoberfläche vermeiden zu können.

Die Erfindung betrifft auch ein Verfahren zum Ausrichten eines Wafers mittels einer Ausrichtvorrichtung der Erfindung, wobei ein Drehteller der Ausrichtvorrichtung mit einem Wafer derart beladen wird, dass der Wafer nur mit seinem Rand auf dem Drehteller aufliegt, um eine Verschmutzung der Waferoberfläche beim Ausrichten bzw. Positionieren des Wafers in eine Bearbeitungsposition vermeiden zu können.

Nachdem der Wafer durch Drehen des Drehtellers seine WaferReferenzposition erreicht hat, wird der Wafer von dem Drehteller bevorzugt derart entfernt bzw. abgehoben, dass der Drehteller o□ne Wafer gedreht werden kann, dass der Wafer selbst nicht gedreht wird und dass der Wafer beim Entfernen von dem Drehteller nur□an seinem Rand berührt wird.

Der leere Drehteller, der bevorzugt vier Stege haben kann, wobei jeweils zwei benachbarte Stege um 90 ° auseinanderliegen, kann dann derart gedreht werden, dass die Kerbe des Wafers mittig zwischen zwei benachbarten, vorgegebenen Stegen angeordnet ist, und dass dann der Drehteller wieder mit diesem Wafer beladen wird. Aufgrund der mittigen Anordnung der Kerbe des Wafers zwischen zwei bestimmten, benachbarten Armen bzw. Stegen des Drehtellers können reproduzierbare Bearbeitungsverhältnisse erreicht werden.

Die Vorrichtung der Erfindung kann eine Versatzdetektionseinrichtung haben, die ein Versatzsignal oder Versatzinformationen oder -daten erzeugt, die ein Maß für den Unterschied zwischen einer Soll-Bearbeitungsposition, in der ein Wafer von einer Bearbeitungsvorrichtung bearbeitete werden soll, und einer tatsächlichen Ist-Bearbeitungsposition des Wafers auf dem Drehteller wiedergibt.

Bevorzugt hat die Versatzdetektionseinrichtung mindestens eine Kameraeinrichtung zum Aufnehmen eines Bilds oder Teilbilds eines Wafers und eine Lichtquelle zum Bestrahlen zumindest eines Teils des Wafers.

Der Drehteller kann über eine Einrichtung zum Halten eines Wafers oder eine Hebeeinrichtung der Ausrichtvorrichtung beladen oder entladen werden. Dies hat den Vorteil, dass der Drehteller auch bei einem sperrigen Roboterarm, wenn die Platzverhältnisse keine direkte Beschickung des Drehtellers erlauben, indirekt über die Halteeinrichtung oder die Hebeeinrichtung der Ausrichtvorrichtung beladen und auch wieder entladen werden kann, wodurch die Anpassung der Ausrichtvorrichtung an unterschiedliche Beschickungssysteme erleichtert werden kann. Die Halteeinrichtung oder die Hebeeinrichtung wird dabei direkt mit einem Wafer von z.B. einem Endeffektor eines Roboterarms beladen oder entladen.

Bevorzugt wird der Drehteller nach dem Beladen mit dem Wafer um maximal 360° gedreht und, wenn von einer Kerbe-Detektionseinrichtung eine Kerbe des Wafers aufgrund der Randlagerung des Wafers auf dem Drehteller nicht detektiert werden konnte und der Drehteller wieder in seine Drehtellerreferenzposition erreicht hat, wird der Wafer von dem Drehteller derart entfernt, dass der Drehteller ohne Wafer gedreht werden kann, dass der Wafer selbst nicht gedreht wird und dass der Wafer beim Entfernen von dem Drehteller nur an seinem Rand berührt wird, wobei der leere Drehteller dann derart gedreht wird, und zwar bevorzugt um 30 °, dass die Kerbe des Wafers sicher detektierbar wird, wobei der Drehteller danach wieder mit dem Wafer beladen wird, wobei wieder nur der Rand des Wafers berührt wird, und schließlich der Drehteller mit dem Wafer gedreht wird, bis die Kerbe des Wafers von der Kerbe-Detektionseinrichtung detektiert wird, was bedeutet dass der Wafer dann in der Waferreferenzposition ist, die der Bearbeitungsposition des Wafers entsprechen kann.

Beim Entfernen von dem Drehteller kann der Wafer mittels einer Hebeeinrichtung von dem Drehteller nach oben abgehoben werden, wobei der Wafer bei dieser Hubbewegung ausschließlich mit seinem Rand auf mindestens einer konischen Fläche der Hebeeinrichtung aufliegt, um wiederum eine Verunreinigung der Waferoberfläche vermeiden zu können.

Bevorzugt wird ein Drehwinkel oder Weg des Drehtellers ständig von einer Wegmesseinrichtung ermittelt, um eine definierte Drehung bzw. Ausrichtung des Wafers in eine Waferreferenzposition oder Waferbearbeitungsposition ermöglichen zu können.

Weitere vorteilhafte Weiterbildungen der Erfindung sind den Unteransprüchen zu entnehmen.

Weitere Vorteile, Anwendungsmöglichkeiten und vorteilhafte Weiterbildungen der Erfindung sind der nachfolgenden, detaillierten Beschreibung bevorzugter und beispielhafter Ausführungsformen der Erfindung in Verbindung mit den Zeichnungen zu entnehmen. Es zeigen:
- Fig. 1: eine perspektivische Ansicht einer Ausführungsform der Vorrichtung der Erfindung mit einem drehkreuzförmigen Teller und einer Hebeeinrichtung;
- Fig. 2: eine perspektivische Ansicht einer weiteren Ausführungsform der Ausrichtvorrichtung der Erfindung mit einem aufgelegten Wafer, drei schematisch eingezeichneten Detektionskameras und einer gegenüber der Ausführungsform von Fig. 1 modifizierten Hebeeinrichtung;
- Fig. 3: eine perspektivische, herausgelöste Detailansicht der Hebeeinrichtung von Fig. 2;
- Fig. 4: eine seitliche Ansicht des Drehtellers von Fig. 2;
- Fig. 5: eine Draufsicht auf den Drehteller von Fig. 2 in Richtung des Pfeils V in Fig. 4 gesehen;
- Fig. 6: eine perspektivische, herausgelöste Ansicht des in der Ausführungsform der Erfindung von Fig. 2 verwendeten Drehtellers;
- Fig. 7: eine schematische Schnittansicht eines Auflageteils der Fig. 4 mit angedeutetem, aufliegendem Wafer; und
- Fig. 8: eine schematische Schnittansicht eines Auflageteils der Hebeeinrichtung von Fig. 1 oder Fig. 3 mit angedeutetem, aufliegendem Wafer.

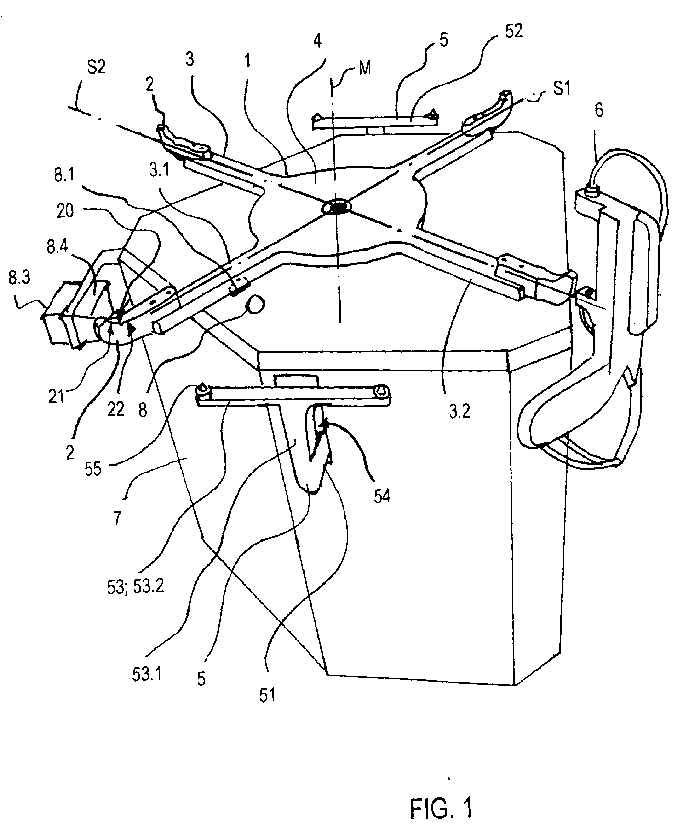

Die in Fig. 1 gezeigte, beispielhafte Ausführungsform der Ausrichtvorrichtung der Erfindung hat einen Drehteller 1, eine Hebeeinrichtung 5, eine Detektionseinrichtung 6 und ein Gehäuse 7, in und an dem die Einrichtungen angeordnet und gehaltert sind.

Der Drehteller kann unabhängig von der speziellen Ausführungsform allgemein z.B. aus Aluminium oder bevorzugt aus Kohlefaserverbundwerkstoff gefertigt sein.

Ein Drehteller aus Kohlefaserverbundwerkstoff kann z.B. aus einer hochfesten Carbon-Prepreg-Platte z.B. durch Fräsen gefertigt werden. Bevorzugt wird hierzu eine Carbonplatte aus HT-Kohlenstoffasergewebe-Prepreg mit Epoxidharzmatrix oder eine Carbonplatte aus einem gepressten und getemperten Nasslaminat verwendet.

Bevorzugt sind die Oberflächen des Drehtellers verschlossen, um eine ungewollte Materialabscheidung oder Materialausdampfung des Drehtellermaterials zu vermeiden. Zum Verschließen wird bei einem Drehteller aus Aluminium bevorzugt ein Hard Coating der Drehtelleroberfläche verwendet. Bei einem Drehteller aus Kohlefaserverbundwerkstoff kann zum Verschließen der Drehtelleroberfläche eine Lackbeschichtung im Tauchbad verwendet werden.

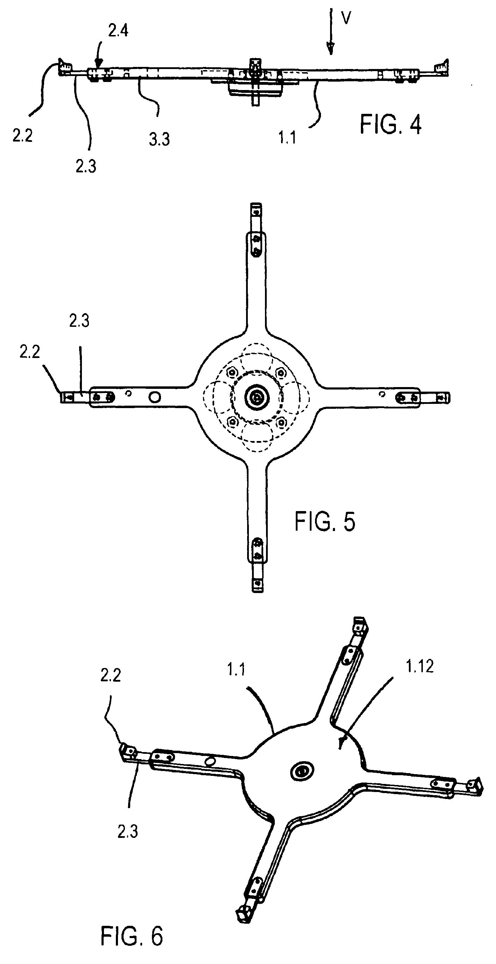

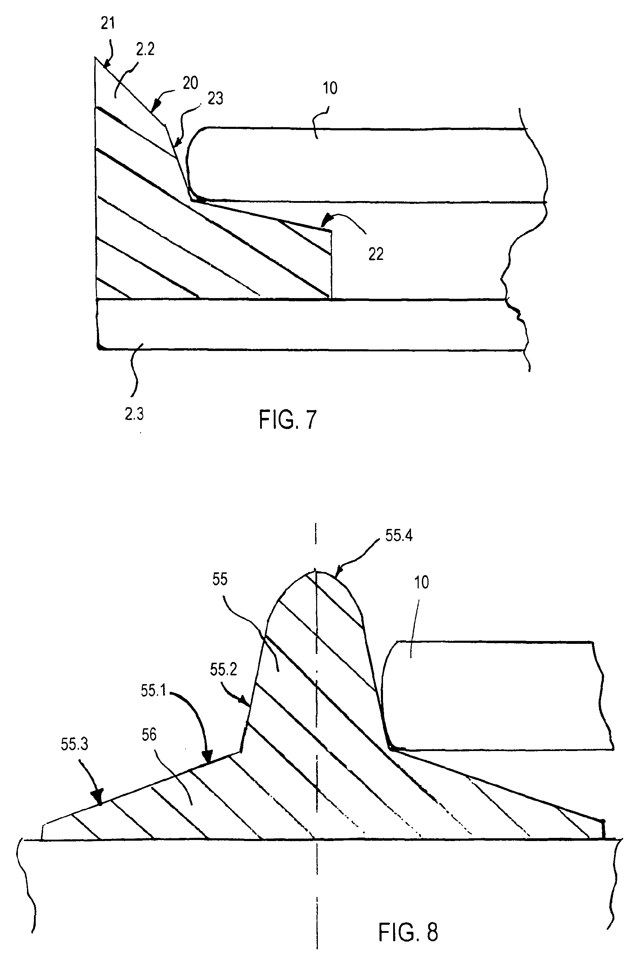

Der Drehteller 1 (oder 1.1, vgl. Fig. 4), hier z.B. aus Aluminium, weist eine zentrale, kreisförmige Scheibe 4 und mehrere relativ schmale Stege 3 bzw. Arme auf, die sich von der kreisförmigen Scheibe 4 des Drehtellers 1 radial nach außen erstrecken und an ihren freien Enden auflagerlos sind, also als Ausleger ausgelegt sind. In der in Fig. 1 gezeigten Ausführungsform der Erfindung sind insgesamt vier, gleichlange Stege 3 ausgebildet, wobei ein Winkel zwischen den Mittenachsen S1 und S2 jeweils zweier, benachbarter Stege 3 genau 90° beträgt. Jeder Steg 3 hat an seinem freien Ende ein Auflageteil 2, auf dem ein auszurichtender bzw. zu bearbeitender Wafer aufliegt. Genauer liegt der kreisrunde, scheibenförmige Wafer oder Siliziumwafer ausschließlich mit seinem Rand oder seinem Randbereich auf den vier Auflageteilen 2 der zugehörigen Stege 3 des Drehtellers 1 auf und kommt folglich nicht mit den sonstigen Oberflächen der Stege 3 oder der zentralen Scheibe 4 des Drehtellers 1 in Berührung (vgl. auch Fig. 4 und Fig. 7).

Genauer gesehen hat jedes Auflageteil 2 (vgl. auch das Auflageteil 2.2 von Fig. 7) eine gegenüber der Waagrechten geneigte Fläche 20, die wiederum in eine obere, ebene Fläche 21, eine daran anschließende mittlere, steiler geneigte Fläche 23 und eine diese fortsetzende, untere, geneigte, ebene Fläche 22 unterteilt ist. Die obere Fläche 21 hat eine mittlere Neigung, bevorzugt einen Neigungswinkel von etwa 45°, gegenüber einer ebenen Oberseite 1.12 des Drehtellers 1, die der waagrechten oder horizontalen Ebene entspricht, welche eine Mittenachse M des Drehtellers 1 senkrecht schneidet. Die mittlere Fläche 23 ist steiler, bevorzugt etwa 70 °, als die obere Fläche 21 und hat die Funktion eines Anschlags für den Waferrand, wenn der Wafer seine waagrechte Lage auf den Auflageteilen 2 bzw. 2.2 des Drehtellers 1 bzw. 1.1 eingenommen hat. Die untere Fläche 22 hat dagegen eine geringere Neigung als die obere Fläche 21 und die mittlere Fläche 23, und zwar bevorzugt etwa 12,5°, gegenüber der waagrechten Ebene.

Die Neigung der Fläche 20 erstreckt sich von oben nach unten zu der waagrechten Drehtellerebene bzw. Oberseite 1.12 und zu der Drehachse M des Drehtellers 1 hin gesehen. Die Auflageteile 2, 2.2 bestehen z.B. aus einem Polyaryletherketon, insbesondere Polyetheretherketon (PEEK). Die gesamte geneigte Fläche 20 und damit auch ihre Teilflächen, die obere Fläche 21, die mittlere Fläche 23 und die untere Fläche 22, sind poliert.

Ist der Drehteller zum Beispiel aus einem Kohlefaserverbundwerkstoff gefertigt, ist er von der Form her bevorzugt im wesentlichen als ebene, kreisförmige Scheibe ausgebildet, die gleichmäßig verteilte Löcher oder materialumschlossene Ausfräsungen haben kann, um Gewicht einzusparen. Am geschlossenen Umfang der Kohlefaserscheibe sind in einem Winkelabstand von jeweils 90 ° Vorsprünge ausgebildet, die jeweils ein Auflageteil 2.2 (vgl. Fig. 7) tragen und haltern.

Der Drehteller 1 (und auch 1.1) wird mit einem elektromotorischen Antrieb angetrieben, z.B. mit einem Schrittmotor oder bevorzugt einem Gleichstromservomotor. Eine Wegmesseinrichtung bzw. Drehwinkelmesseinrichtung (nicht gezeigt) ist vorgesehen, die den vom Drehteller 1 zurückgelegten Weg oder Drehwinkel ständig richtungsabhängig derart detektiert bzw. misst, dass die tatsächliche Position des Drehtellers 1 gegenüber einer Drehtellerreferenzposition oder Anfangsposition bekannt ist.

Wird ein Schrittmotor für den Drehantrieb des Drehtellers 1 verwendet, summiert oder subtrahiert die Wegmesseinrichtung die Ansteuerimpulse des Schrittmotors ausgehend von der Drehtellerreferenzposition richtungsabhängig in einem elektronischen Zähler oder Register, wobei der Zählerstand ein Maß für den zurückgelegten Drehweg bzw. die momentane Position des Drehtellers gegenüber der Drehtellerreferenzposition ist. Wird ein Servomotor eingesetzt, führt die Wegmesseinrichtung eine elektrooptische Inkrementalwinkelerfassung durch, die mit einer Strichscheibe oder einem Strichlineal bzw. einem Encoder arbeitet, um richtungsabhängige elektrische Impulse zu erzeugen, die wiederum in einem Zähler oder einem Register richtungsabhängig summiert oder subtrahiert werden, um die momentane Position des Drehtellers 1 angeben zu können.

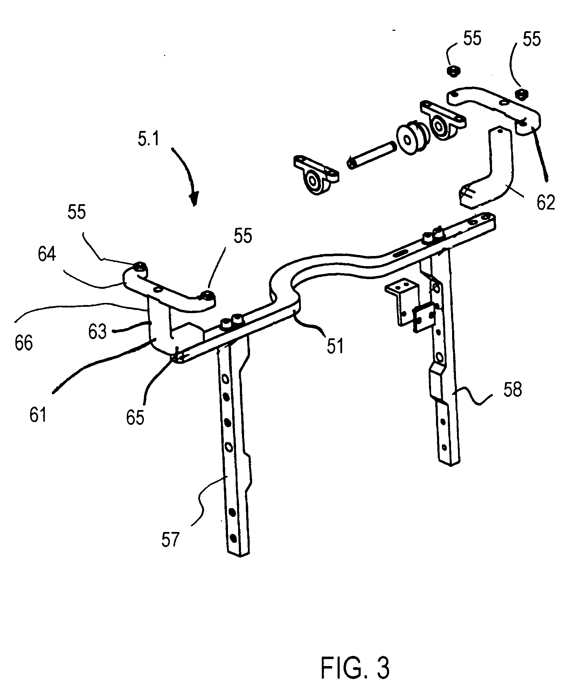

Die Hebeeinrichtung 5 der Fig. 1 weist einen Querträger 51, der mit seinen auflagerlosen, freien Enden aus dem Gehäuse 7 durch entsprechende Längsschlitze 54 nach außen heraussteht, und zwei baugleiche, gegenüberliegende T-förmige Tragteile 52, 53 auf, die an den freien Enden des Querträgers 51 außerhalb des Gehäuses 7 der Ausrichtvorrichtung gemäß Fig. 1 angebracht sind (vgl. auch die modifizierte Ausführungsform von Fig. 3).

Der Querträger 51 erstreckt sich senkrecht zur Drehachse M des Drehtellers 1 zum großen Teil im Inneren des Gehäuses 7. Das T-förmige Tragteil 53 hat einen senkrechten, geraden Schenkel 53.1 und einen waagrechten, geraden Schenkel 53.2, der an den senkrechten Schenkel 53.1 anschließt und mittig auf diesem ausgebildet ist, wobei eine Mittenachse des Schenkels 53.2 orthogonal zu einer Mittenachse des senkrechten Schenkels 53.1 ist.

Die Hebeeinrichtung 5 ist allgemein wiederum derart ausgebildet, dass beim Aufnehmen eines Wafers von dem Drehteller 1 aus der Wafer 10 ausschließlich mit seinem Rand bzw. Randbereich auf der Hebeeinrichtung 5 aufliegt. Die Hebeeinrichtung 5 hat hierfür mindestens zwei sich gegenüberliegende, konische oder geneigte Flächen 55.1, zwischen denen und auf denen ein aufgenommener Wafer ausschließlich mit seinem Rand bzw. Randbereich aufliegt, wenn die Hebeeinrichtung 5 den Wafer 10 von dem Drehteller 1 aus aufnimmt. Diese konischen oder geneigten Aufnahmeflächen 55.1 der Hebeeinrichtung 5 sind in der Ausführungsform der Erfindung von Fig. 1 durch an der Spitze abgerundete, konische, rotationssymmetrische Stifte 55 mit einer verbreiterten Basis 56 realisiert, die kreisrund scheibenförmig ist und radial nach außen konisch abgeflacht ist. An jedem der beiden, freien, auflagerlosen Enden des Schenkels 53.2 und auch an jedem der beiden freiliegenden Enden des entsprechenden Schenkels des T-förmigen Tragteils 52 ist oberseitig jeweils ein konischer Stift 55 bzw. Spitzkegel mit der verbreiterten Basis 56 angebracht (vgl. auch Fig. 8).

Die geneigte Fläche 55.1 des Stifts 55 hat eine obere, abgerundete Fläche 55.4, eine daran anschließende, mittlere, geneigte Umfangsfläche 55.2, die bevorzugt einen Neigungswinkel von 70 ° zur Waagrechten aufweist und als Anschlag für den Waferrand dient, wenn der Wafer 10 seine waagrechte Lage auf den Stiften 55 der Hebeeinrichtung 5 eingenommen hat, und die daran anschließende, konisch abflachende Fläche 55.3 der Basis 56, die bevorzugt einen Neigungswinkel gegenüber der Waagrechten von 10 ° hat.

Die konischen Stifte 55 sind z.B. aus einem Polyaryletherketon, insbesondere Polyetheretherketon (PEEK), hergestellt und ihre Oberflächen sind bevorzugt poliert.

Um den Wafer vom Drehteller 1 abheben zu können, führt die Hebeeinrichtung 5 eine lineare Hubbewegung in Richtung parallel zur Drehachse M des Drehtellers 1 durch, die durch eine weitere Antriebseinrichtung, die mit der Hebeeinrichtung 5 gekoppelt ist, ausgeführt wird. Die Antriebseinrichtung (nicht gezeigt) kann hierzu einen Servomotor bzw. Gleichstrommotor haben, der über ein Getriebe, das eine Bremse hat, mit der Hebeeinrichtung 5 gekoppelt ist. Das Getriebe kann zum Beispiel einen senkrecht angeordneten Zahnriemen haben, der mit der Hebeeinrichtung 5 fest gekoppelt ist und sich zwischen einem Antriebszahnrad und einem Umlenkzahnrad erstreckt, wobei die Drehbewegung des Motors über das Antriebszahnrad auf den Zahnriemen übertragen wird, der dann die Hebeeinrichtung 5 nach oben oder nach unten linear bewegt.

Wie in Fig. 3 genauer gezeigt ist, hat die Hebeinrichtung 5 senkrecht, d.h. parallel zur Drehtellerachse M, sich erstreckende Stäbe 57 und 58, die in jeweils zugehörige Führungen (nicht gezeigt) im Gehäuse 7 geführt sind, um eine gleichmäßige und verkantungsfreie Hubbewegung der Hebeeinrichtung 5 ermöglichen zu können.

Die in Fig. 3 gezeigte, modifizierte Hebeeinrichtung 5.1 hat im Vergleich zur Hebeeinrichtung 5 von Fig. 1 modifizierte Tragteile 61 und 62 an den freien Enden des Querteils 51. Die Tragteile 61 und 62 sind gegenüberliegend und haben jeweils ein Winkelteil 63, das mit einem Schenkel 65 an einem Ende oder Endabschnitt des Querteils 51 angebracht ist, und einen im Grundriss c-förmigen Querschenkel 64, der mittig an dem Ende des anderen Schenkels 66 des Winkelteils 63 angebracht ist. Die freien Enden des c-förmigen Querschenkels 64 befinden sich außerhalb des Gehäuses 7, wenn die Hebeeinrichtung 5.1 mit den modifizierten Tragteilen 61 und 62 in das Gehäuse 7 eingebaut ist, und weisen dann zur Drehachse M des Drehtellers 1 hin. An jedem der freien Enden der beiden Querschenkel 64 der Tragteile 61 und 62 ist jeweils ein konischer Stift 55 angeordnet und befestigt, dessen abgerundete Spitze nach oben weist. Die c-Form des Querschenkels 64 hat den Vorteil, dass der Randbereich des Wafers 10 zwischen den konischen Stiften 55 und auch die Enden der Stege 3 mit den Auflageteilen 2 oder 2.2 nicht mit dem Winkelteil 63 in Berührung kommen und dass das Winkelteil 63 außerhalb des Drehbereichs des Drehtellers 1 (bzw. 1.1) ist.

Der Abstand zwischen den konischen Stiften 55 auf dem Querschenkel 64 ist derart ausgelegt, dass der Wafer 10 von den Stiften 55 der beiden gegenüberliegenden Tragteile 61 und 62 sicher abgestützt wird, aber andererseits ein möglichst großer Korrekturwinkel zwischen den Stegen 3 ermöglicht wird.

Die Detektionseinrichtung 6 bzw. Kerbe-Detektionseinrichtung hat einen elektrooptischen Sender, z.B. eine Lumineszenzdiode oder Laserdiode, der elektromagnetische Strahlung, z.B. Licht, abstrahlt, und einen elektrooptischen Empfänger, z.B. eine Photodiode, die die von dem elektrooptischen Sender abgegebene Strahlung empfängt und ein entsprechendes elektrisches Detektionssignal erzeugt. Der Empfänger und der Sender stehen sich mit Abstand zueinander derart gegenüber, dass ein auf dem Drehteller 1 aufliegender Wafer in den Lichtstrahl zwischen Sender und Empfänger eingreift und nach dem Prinzip einer Lichtschranke unterbricht, wodurch dann keine Strahlung zum Empfänger gelangen kann, außer die Randkerbe 90 des Wafers 10 liegt gerade im Strahlengang der Detektionseinrichtung 6, was gleichbedeutend damit ist, dass der Strahl vom Sender zum Empfänger nicht unterbrochen wird sondern zum Empfänger gelangt, wodurch ein entsprechendes Detektionssignal vom Empfänger erzeugt wird. Die Detektionseinrichtung 6 kann in Alternative auch derart ausgelegt sein, dass der Wafer 10 als Reflektor dient, der das Licht bzw. die Strahlung vom Sender auf den Empfänger reflektiert, außer die Randkerbe 90 erreicht den Strahlengang des Senders, wodurch der Strahl durch die Randkerbe 90 hindurchgeht und nicht am Wafer reflektiert wird und der Empfänger folglich keinen reflektierten Strahl mehr empfängt und ein entsprechendes Detektionssignal erzeugt. Die Erzeugung und Ausgabe des Detektionssignals bedeutet also, dass der Wafer 10 eine vorgesehene Position bzw. Waferreferenzposition erreicht hat.

Die Ausrichtvorrichtung der Erfindung hat auch eine Drehtellerdetektionseinrichtung zum Detektieren, ob sich der Drehteller 1 in einer vorgegebenen Drehtellerreferenzposition befindet. Die Drehtellerdetektionseinrichtung kann z.B. einen induktiven Sensor 8 haben, der in Wechselwirkung mit z.B. einem magnetischen oder einem metallenen Referenzteil 8.1 kommt, das an einer vorgegebenen Stelle befestigt ist, z.B. mittig an der Unterseite eines Stegs 3 des Drehtellers 1, und ein elektrisches Sensorsignal erzeugt, wenn sich das Referenzteil 8.1 über dem induktiven Sensor 8 bzw. in dessen Erfassungsbereich befindet. Der Sensor 8 ist an bzw. in einem Deckel des Gehäuses 7 untergebracht und befestigt.

Zudem kann die Ausrichtvorrichtung eine Detektionseinrichtung 8.3 zum Detektieren haben, ob sich der Endeffektor eines Roboterarms zur Beschickung der Ausrichtvorrichtung im Störkreis oder Drehkreis des Drehtellers 1 befindet. Insbesondere kann die Detektionseinrichtung 8.3 das Nichtvorhandensein des Endeffektors im Störkreis des Drehtellers 1 erfassen und der Steuereinrichtung mitteilen. Die Detektionseinrichtung 8.3 kann einen elektrooptischen Sensor, z.B. einen Reflexsensor, haben.

Die Ausrichtvorrichtung kann weiterhin auch eine Detektionseinrichtung 8.4 zum Detektieren haben, ob sich der Wafer 10 auf dem Drehteller 1 oder in einer alternativen Ausführungsform auf der Hebeeinrichtung 5 befindet. Insbesondere kann die Detektionseinrichtung 8.4 das Vorhandensein oder Nichtvorhandensein des Wafers 10 auf dem Drehteller 1 detektieren und der Steuereinrichtung mitteilen. Die Detektionseinrichtung 8.4 kann einen elektrooptischen Sensor, z.B. einen Reflexsensor, haben, wobei der Sensor der Detektionseinrichtung 8.4 radial weiter innenliegend zur Drehachse M des Drehtellers 1 hin gesehen als die Detektionseinrichtung 6 angeordnet ist.

Die Steuereinrichtung der Ausrichtvorrichtung der Erfindung ist z.B. ein programmgesteuerter Mikrocomputer oder Mikrocontroller, der elektrisch über entsprechende Kabelverbindungen und Schnittstellen mit dem elektromotorischen Drehtellerantrieb des Drehtellers 1, dem elektromotorischen Hubantrieb der Hebeeinrichtung 5, der Detektionseinrichtung 6, der Drehteller-Detektionseinrichtung 8, den Detektionseinrichtungen 8.3 und 8.4 und der Wegmesseinrichtung verbunden ist, um die Drehung des Drehtellers 1 über den zugehörigen Drehtellerantrieb und die lineare Hubbewegung der Hebeeinrichtung 5 über den zugehörigen Hubantrieb in Abhängigkeit von bzw. Antwort auf die Detektionssignale von der Detektionseinrichtung 6, der Drehteller-Detektionseinrichtung 8, den Detektionseinrichtungen 8.3 und 8.4 und dem von der Wegmesseinrichtung ermittelten, zurückgelegten Weg bzw. der Momentanwinkelposition des Drehtellers 1 steuern zu können. Von der Steuereinrichtung werden nicht nur sämtliche Einrichtungen der Ausrichtvorrichtung sondern auch sämtliche Verfahrensschritte des Ausrichtverfahrens der Erfindung gesteuert.

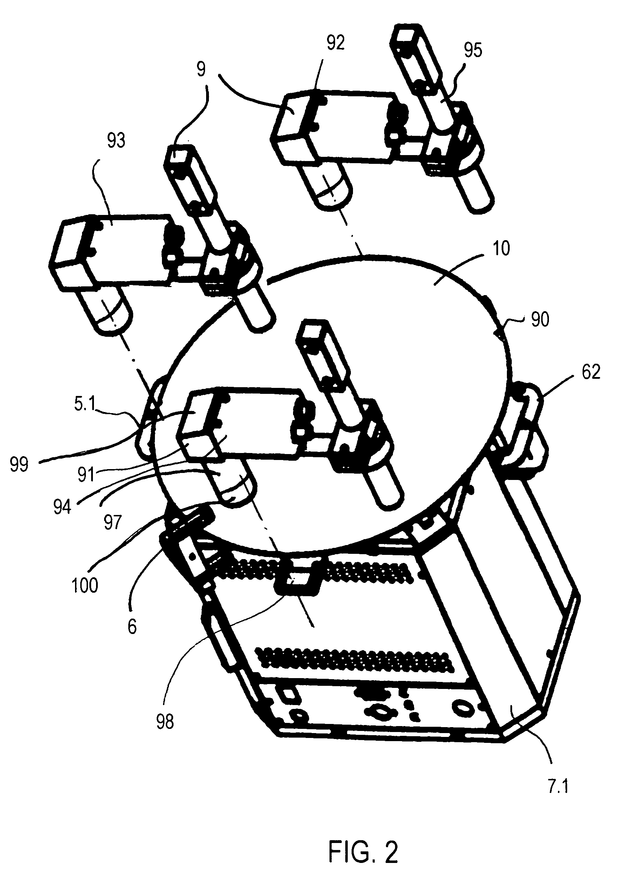

Die in Fig. 2 gezeigte weitere Ausführungsform der Ausrichtvorrichtung der Erfindung ist in den gezeigten Ansichten mit einem auf dem modifizierten Drehteller 1.1 (vgl. insbesondere Fig. 4, Fig. 5 und Fig. 6) aufliegenden Wafer 10 gezeigt, der z.B. einen Durchmesser von 300 mm haben kann und ein Siliziumwafer sein kann.

Der Drehteller 1.1 von Fig. 4 bis 6 ist gegenüber dem Drehteller 1 von Fig. 1 im wesentlichen bezüglich der Auflageteile 2.2 und der Anbringung der Auflageteile 2.2 an den freien, auflagerlosen Enden der Stege 3.2 des Drehtellers 1.1 modifiziert. Das Auflageteil 2.2 von Fig. 10 ist auf einem Ende eines relativ dünnen, blattförmigen, länglichen Trägers 2.3 befestigt, z.B. angeschraubt, während das andere Ende des Trägers 2.3 in einer passend ausgebildeten Aufnahme 2.4 des jeweiligen Stegs 3.2 eingesetzt und darin befestigt ist, z.B. angeschraubt ist. Die geneigte Fläche 20, einschließlich ihrer oberen Teilfläche 21, der mittleren Fläche 23 und der unteren Fläche 22 des Auflageteils 2.2 und auch des Auflageteils 2 von Fig. 1 liegt höher als die gesamte Oberseite 1.12 des Drehtellers 1.1 oder 1.

Die weitere Ausführungsform hat ein Gehäuse 7.1, in dem wiederum wie bei dem Gehäuse 7 von Fig. 1 die Steuereinrichtung mit dem Mikrocomputer, Schnittstellenelektronik mit zugehöriger Verkabelung, die Stromversorgung für sämtliche elektrischen Verbraucher und Einrichtungen der Ausrichtvorrichtung, die elektromotorischen Antriebe für die Hebeeinrichtung 5.1 (vgl. Fig. 3) und den Drehteller 1.1 (vgl. insbesondere Fig. 4, Fig. 5 und Fig. 6) untergebracht sind. Zusätzlich zu der Ausführungsform von Fig. 1 ist jedoch in der Ausführungsform von Fig. 2 eine Versatzdetektionseinrichtung 9 vorgesehen, die zum Detektieren und Erkennen eines Versatzes des auf dem Drehteller 1.1 aufliegenden Wafers 10 gegenüber einer vorgegebenen Referenzposition oder Sollposition eines Wafers verwendet wird, wobei als Versatz die Differenz bzw. die Unterschiede zwischen der Istposition eines zu bearbeitenden Wafers und der vorgegebenen Sollposition des Wafers 10 betrachtet wird. Aus diesen Unterschieden ermittelt die Versatzdetektionseinrichtung 9 z.B. kartesische Versatzkoordinaten (xᵥ,yᵥ) einer horizontalen Ebene, die der obenliegenden Seite des Wafers 10 entspricht bzw. zu dieser zumindest parallel ist.

In der gezeigten beispielhaften und bevorzugten Ausführungsform von Fig. 2 hat die Versatzdetektionseinrichtung 9 eine erste Kameraeinrichtung 91, eine zweite Kameraeinrichtung 92 und eine dritte Kameraeinrichtung 93, die baugleich sind.

Die Kameraeinrichtungen 91, 92 und 93 haben jeweils z.B. ein Objektiv 97 und eine elektrische CCD-Einrichtung (CCD = Charge Coupled Device) 94 zum Aufnehmen eines Bilds oder Teilbilds des Wafers 10, eine Lichtquelle 98 zum Bestrahlen zumindest eines Teils des Wafers 10 und eine Halterung 95, mit der die Objektiv-CCD-Einheit der jeweiligen Kameraeinrichtung an einem Rahmen oder Gehäuse einer Waferbearbeitungsvorrichtung angebracht ist. Jede der Kameraeinrichtungen 91, 92, 93 kann einen Umlenkspiegel 99 zum Umlenken der Lichtstrahlen vom Objektiv 97 auf die CCD-Einrichtung 94 haben, um eine platzsparende Bauweise der Kameraeinrichtungen 91, 92, 93 ermöglichen zu können.

Die erste Kameraeinrichtung 91 der Versatzdetektonseinrichtung 91 wird zum Ermitteln eines Versatzes eines Wafers 10 zu einer vorgegebenen Soll-Waferbearbeitungsposition an einer Kerbe 90 des Wafers 10 verwendet.

Die dritte Kameraeinrichtung 93 der Versatzdetektionseinrichtung 9 wird zum Ermitteln eines Versatzes eines Wafers zu einer vorgegebenen Soll-Waferbearbeitungsposition an einem Abschnitt des kreisförmigen Rands oder der Kante eines Wafers verwendet. Die dritte Kameraeinrichtung 93 ist bevorzugt um einen Winkel von 90 ° von der ersten Kameraeinrichtung 91 über dem Rand des Wafers versetzt angeordnet.

Die optional zweite Kameraeinrichtung 92 wird zum Ermitteln eines Versatzes eines Wafers zu einer vorgegebenen Soll-Waferbearbeitungsposition an einer Kerbe 90 eines Wafers 10 verwendet, wobei die zweite Kameraeinrichtung 92 um einen Winkel von 180 ° von der ersten Kameraeinrichtung 91 über dem Rand des Wafers versetzt angeordnet ist.

Die CCD-Einrichtung 94 kann z.B. einen zweidimensionalen, also flächigen, CCD-Chip oder eine eindimensionale CCD-Zeile haben. Vor dem Objektiv 97 ist bevorzugt ein optisches Filter 100 in jeder Kameraeinrichtung 91, 92, 93 angeordnet, das einen bestimmten, ausgewählten Lichtwellenlängenbereich des einfallenden Lichts durchlässt. Bevorzugt ist ein Infrarot-Filter als optischer Filter 100 vorgesehen, der nur infrarotes Licht durchlässt und somit andere, unerwünschte Lichtbestandteile abblockt, z.B. Streulicht von außen, die ansonsten die Detektion stören oder verfälschen könnten.

Die Lichtquelle 98, die bei auf dem Drehteller aufliegendem Wafer 10 unter dem Wafer 10 angeordnet ist, hat bevorzugt eine Infrarotlichtquelle, die z.B. eine Lumineszenzdiode oder mehrere Lumineszenzdioden aufweist, die Licht im Infrarotbereich abgibt bzw. abgeben, und einen Diffusor, auf den das Infrarotlicht gestrahlt wird und der ein diffuses Licht mit gleichmäßiger Lichtverteilung erzeugt, das auf den Wafer 10, insbesondere auf seinen Randbereich, strahlt. Der Diffusor kann eine transparente, weiße bzw. milchige Plexiglasscheibe oder mehreren solche hintereinander im Strahlengang angeordnete Plexiglasscheiben aufweisen.

Nachfolgend wird ein Beispiel für ein Verfahren der Erfindung zum Ausrichten eines Wafers mittels der vorstehend beschriebenen Ausrichtvorrichtung erläutert.

Ganz am Anfang, wenn die Detektionseinrichtung 8.3 das Nichtvohandensein eines Endeffektors eines Roboterarms meldet und wenn die Detektionseinrichtung 8.4 das Nichtvorhandensein eines Wafers meldet, wird in einem ersten Schritt, noch vor der Ablage eines Wafers auf dem Drehteller 1 bzw. 1.1 der Ausrichtvorrichtung, der leere Drehteller 1 unter Auswertung und Berücksichtigung des Signals von dem induktiven Sensor der Drehteller-Detektionseinrichtung 8 mittels der Antriebseinrichtung in eine Drehtellerreferenzposition gedreht und in der Wegmesseinrichtung wird das Register der Wegmessung oder - zählung für den Drehteller auf Null gesetzt.

Anschließend wird in einem zweiten Schritt ein zu bearbeitender Wafer 10, z.B. ein Wafer mit einem Durchmesser von 300 mm, unter Verwendung z.B. eines Roboterarms mit Endeffektor auf den ruhenden Drehteller 1 (oder 1.1) abgelegt. Ein Beispiel für einen Roboterarm mit Endeffektor ist z.B. in der DE 102004024366 beschrieben, deren Inhalt hier durch Bezugnahme aufgenommen wird. Durch eine entsprechende Justage und Einstellung der räumlichen Bewegung des Roboterarms, wird erreicht, dass der Wafer 10 beim Ablegen auf dem Drehteller 1 alleine mit seinem kreisrunden Rand mit den geneigten Flächen 20 der Auflageteile 2 oder 2.2 in Berührung kommt und von den vier Auflageteilen 2 des Drehtellers 1 getragen wird. Durch die geneigten Flächen 20 wird ein Toleranzbereich für die Ablageposition des Roboterarms vorgegeben. Aufgrund der polierten, unterschiedlich geneigten Flächen 21, 22 und 23 rutscht bzw. gleitet der Wafer selbsttätig, wenn er mit seinem Rand oder Randbereich unmittelbar nach der Ablage durch den Roboterarm schiefwinklig auf den geneigten Flächen 20 der Auflageteile 2 oder 2.2 aufliegt, an den steileren Flächen 21 und 23 nach unten und an den weniger steileren bzw. schwach geneigten, unteren Flächen 22 nach oben in die vorgegebene Normallage auf den vier Auflageteilen 2 in Anschlag mit den mittleren Flächen 23. In der Normallage auf den Auflageteilen 2 des Drehtellers 1 ist der Wafer 10 in der vorgesehenen waagrechten bzw. horizontalen Lage. Der Abstand zwischen den mittleren Flächen 23 der geneigten Flächen 20 von zwei sich gegenüber liegenden Auflageteilen 2 am Drehteller 1 beträgt etwa 300 mm bzw. das obere Toleranzmaß für den Waferdurchmesser.

Bei einem alternativen, zweiten Schritt des Verfahrens wird der Wafer vom Roboterarm zuerst auf der Hebeeinrichtung 5 abgelegt. Genauer wird zu Beginn des alternativen, zweiten Schritts die Hebeeinrichtung 5 zuerst unter der Steuerung der Steuereinrichtung über die zugehörige Antriebseinrichtung nach oben in eine Lade/Entlade-Position gefahren bzw. angehoben und festgehalten. Befindet sich die Hebeeinrichtung 5 jedoch bereits in ihrer Lade/Entlade-Position oder ist sie darin verblieben, entfällt das Hochfahren in die Lade/Entlade-Position. Ein zu bearbeitender Wafer 10, z.B. ein Wafer mit einem Durchmesser von 300 mm, wird nun unter Verwendung des Roboterarms mit Endeffektor direkt auf der ruhenden Hebeeinrichtung 5 (oder 1.1) in ihrer Lade/Entlade-Position abgelegt.

Wird der zweite, alternative Schritt durchgeführt, werden als Auflageteile der Hebeeinrichtung 5 (oder 5.1) anstelle der konischen Stifte 55 jedoch die Auflageteile 2.2 (vgl. Fig. 4) des Drehtellers 1.1 verwendet, die einen größeren Toleranzbereich als die Stifte 55 für die Aufnahme des Wafers 10 auf der Hebeeinrichtung 5 bereitstellen.

Durch eine entsprechende Justage und Einstellung der räumlichen Bewegung des Roboterarms, wird auch beim zweiten, alternativen Schritt erreicht, dass der Wafer 10 beim Ablegen auf der Hebeeinrichtung 5 alleine mit seinem kreisrunden Rand mit den geneigten Flächen 20 der Auflageteile 2 oder 2.2 der Hebeeinrichtung 5 in Berührung kommt und von den vier Auflageteilen 2.2 der Hebeeinrichtung 5 getragen wird. Durch die geneigten Flächen 20 wird ein Toleranzbereich für die Ablageposition des Roboterarms vorgegeben. Aufgrund der polierten, unterschiedlich geneigten Flächen 21, 22 und 23 rutscht bzw. gleitet der Wafer selbsttätig, wenn er mit seinem Rand oder Randbereich unmittelbar nach der Ablage durch den Roboterarm schiefwinklig auf den geneigten Flächen 20 der Auflageteile 2.2 der Hebeeinrichtung 5 aufliegt, an den steileren Flächen 21 und 23 nach unten und an den weniger steileren bzw. schwach geneigten, unteren Flächen 22 nach oben in die vorgegebene Normallage auf den vier Auflageteilen 2.2 in Anschlag mit den mittleren Flächen 23. In der Normallage auf den Auflageteilen 2.2 der Hebeeinrichtung 5 oder 5.1 ist der Wafer 10 in der vorgesehenen waagrechten bzw. horizontalen Lage.

Um den zweiten, alternativen Schritt zu beenden, wird die Hebeeinrichtung 5 mit aufliegendem Wafer dann wieder abgesenkt, wobei der Wafer 10 auf dem Drehteller 1 (oder 1.1) abgelegt wird.

Nach der Ablage des Wafers 10 auf dem Drehteller 1 wird der Drehteller 1 unter entsprechender Steuerung der Steuereinrichtung über den elektromotorischen Antrieb des Drehtellers 1 nun in einem dritten Schritt maximal einmal komplett gedreht, also um einen Winkel von 360 °, wobei bei dieser Anfangsdrehung von der Steuereinrichtung ständig überprüft wird, ob die Detektionseinrichtung 6 ein Signal für die Erkennung der randseitigen Kerbe oder Notch des Wafers erzeugt wird oder nicht.

Wird von der Detektionseinrichtung 6 bei der Anfangsdrehung im dritten Schritt kein Signal oder nur ein Signal erzeugt, das unter einer vorgegebenen Schwelle bzw. unter einem vorgegebenen Schwellenwert liegt, bedeutet dies, dass sich die Kerbe des Wafers vollständig oder zumindest teilweise auf einem der Stege 3 bzw. auf einem der vier Auflageteile 2 bzw. 2.2 des Drehtellers befindet und die Kerbe 90 des Wafers 10 folglich in diesem Fall nicht von der Detektionseinrichtung 6 detektiert werden kann. Der Drehteller 1 bzw. 1.1 ist dann genau um 360° gedreht worden und ruht oder steht nun wieder in seiner Referenzposition. In diesem Fall fährt dann die Hebeeinrichtung 5 nach oben unter der Steuerung der Steuereinrichtung über die zugehörige Antriebseinrichtung und hebt den Wafer 10 von dem Drehteller 1 bzw. 1.1 ab und nimmt den Wafer 10 mit, bis der Wafer 10 über dem Drehteller 1 eine Halteposition erreicht hat, in der die Hebeeinrichtung 5 den Wafer festhält. Bei dieser Hubbewegung liegt der Wafer 10 nur mit seinem Rand auf den konischen Flächen der konischen Stifte 55 an den Enden der Querträger 53 bzw. 64 der Hebeeinrichtung 5 auf oder in Alternative auf den Auflageteilen 2.2 der Hebeeinrichtung 5 auf, wenn das alternative Verfahren mit dem alternativen, zweiten Schritt durchgeführt wird.

Hat der Wafer 10 nun seine Halteposition über dem Drehteller 1 erreicht, wird der Drehteller 1 unter Steuerung der Steuereinrichtung über die Antriebseinrichtung wieder z.B. um 30 ° derart gedreht, dass die Stege 3 bzw. die Auflageteile 2 bzw. 2.2 des Drehtellers 1 bzw. 1.1 sicher zu der Kerbe 90 des Wafers 10 versetzt sind.

Anschließend wird die Hebeeinrichtung 5 unter Steuerung der Steuereinrichtung wieder nach unten bewegt und der Wafer wird wieder auf den Drehteller 1 abgesenkt, wobei der Wafer wieder ausschließlich mit seinem Rand auf den geneigten Flächen 20 der Auflageteile 2 des Drehtellers 1 aufliegt.

Der Drehteller mit aufliegendem Wafer 10 wird dann gedreht, bis ein Detektionssignal von der Detektionseinrichtung 6 abgegeben wird, d.h. dass die Kerbe 90 des Wafers 10 von der Detektionseinrichtung 6 erkannt wird. Der Drehteller 1 wird unter der Steuerung der Steuereinrichtung noch innerhalb des Detektionsbereichs der Detektionseinrichtung 6 gestoppt. Der Wafer ist dann in seiner Waferreferenzposition.

Wird bei der Anfangsdrehung im dritten Schritt dagegen ein Detektionssignal von der Detektionseinrichtung 6 abgegeben, d.h. dass die Kerbe 90 des Wafers 10 von der Detektionseinrichtung 6 erkannt wird und die Kerbe 90 des Wafers 10 nicht auf einem Steg 3 bzw. einem Auflageteile 2 des Drehtellers liegt, wird der Drehteller 1 sofort noch innerhalb des Detektionsbereichs der Detektionseinrichtung 6 gestoppt. Der Wafer ist dann in seiner Waferreferenzposition.

Im nächsten, vierten Schritt wird dann die Hebeeinrichtung 5 von der Steuereinrichtung angesteuert und führt eine geradlinige bzw. lineare Hubbewegung nach oben aus, durch die der Wafer 10 vom Drehteller 1 abgehoben wird und in die Festhalteposition bewegt wird, in der die Hubbewegung der Hebeeinrichtung 5 stoppt und die Hebeeinrichtung 5 den Wafer 10 festhält.

Der leere Drehteller 1 wird nun derart gedreht, dass die Kerbe 90 des Wafers 10 genau mittig zwischen zwei benachbarten Stegen oder Armen des Drehtellers 1, bevorzugt zwischen einem ersten Steg 3.1 und einem benachbarten zweiten Steg 3.2, angeordnet ist. Da die Drehtellerreferenzposition z.B. genau der Stegmitte des ersten Stegs 3.1 zugeordnet ist, kennt die Steuereinrichtung aufgrund des momentanen Werts der Wegmesseinrichtung die genaue Winkelposition des ersten Stegs, wenn der Wafer 10 in seiner Waferreferenzposition ist. Weiterhin ist auch die genaue Winkelposition der Waferreferenzposition zur Drehtellerreferenzposition vorgegeben und bekannt. Der Drehteller 1 wird jetzt gedreht, bis die Mitte des ersten Stegs 3.1 des Drehtellers 1 genau 45 ° vor der Waferreferenzposition ist, bei Drehung des Drehtellers 1 z.B. entgegen dem Uhrzeigersinn gesehen. Die Mitte des zweiten, benachbarten Stegs 3.2 des Drehtellers 1 befindet sich dann genau 45 ° nach der Waferreferenzposition entgegen dem Uhrzeigersinn gesehen, da der Abstand zwischen dem ersten Steg 3.1 und dem zweiten Steg 3.2 genau 90 ° beträgt. Allgemeiner wird der Drehteller 1 hier um w_{D} = w_{RW} - w_{M} - 45° gedreht, um die Mittenstellung der Kerbe 90 des Wafers 10 zwischen dem ersten Steg 3.1 und dem zweiten Steg 3.2 zu erreichen, wobei w_{D} die auszuführende Drehung des Drehtellers 1 z.B. in Richtung entgegen dem Uhrzeigersinn gesehen ist, w_{RW} die Winkelposition der Waferreferenzposition gegenüber der Drehtellerreferenzposition ist, wobei die Drehtellerreferenzposition bevorzugt 0 ° hat, und w_{M} die momentane Winkelposition des Drehtellers 1 ist. Diese Drehung wird wiederum von der Steuereinrichtung berechnet und gesteuert.

Nach Ausführen der Drehung W_{D} wird der Wafer 10 mittels der Hebeeinrichtung 5 wieder auf den Drehteller 1 abgesenkt. Die Kerbe 90 des Wafers 10 befindet sich nun in der Waferreferenzposition und mittig zwischen dem ersten Steg 3.1 und dem zweiten Steg 3.2 des Drehtellers 1. Durch diese mittige Anordnung kann eine gleichbleibende Reproduzierbarkeit bei der Bearbeitung des Wafers eingehalten werden, die ansonsten durch Höhenunterschied der Stege z.B. aufgrund von Fertigungstoleranzen oder auch Lagertoleranzen und auch Beschädigungen des Drehtellers wegen eines Zusammenstoßens zwischen Wafer und Drehteller beim Beladen bzw. Entladen nicht erreicht werden könnte.

In einem nachfolgenden fünften Schritt wird der Drehteller 1 mit Wafer dann in eine vorgegebene Bearbeitungsposition gedreht, in der der Wafer 10 bearbeitet werden soll. Falls die Waferreferenzposition der Bearbeitungsposition entspricht, kann diese Drehung entfallen. Der Ausrichtvorgang ist dann beendet.

Die Bearbeitung des Wafers kann z.B. ein Markieren oder Beschreiben des Wafers mit einem Laserstrahl, das Lesen einer auf dem Wafer vorhandenen Markierung oder das Schneiden oder Anritzen des Wafers mit einem Laserstrahl sein. Um die Bearbeitung des Wafers mit der geforderten hohen Genauigkeit auch Durchführen zu können, wird ein Korrektursignal oder werden Korrekturinformationen oder -daten bzw. ein Versatz mittels der Versatzdetektionseinrichtung 9 erzeugt, die ein Maß für den Unterschied zwischen der Soll-Bearbeitungsposition oder einer Referenzbearbeitungsposition des Wafers und einer Ist-Bearbeitungsposition oder tatsächlichen Bearbeitungsposition des Wafers auf dem Drehteller 1 wiedergibt.

Die ermittelte Versatzkoordinate bzw. der ermittelte Versatz wird dann von der Steuereinrichtung der Ausrichtvorrichtung an die Bearbeitungsvorrichtung ausgegeben, die dann den Versatz bzw. die Versatzkoordinate bei der Bearbeitung des zu bearbeitenden Wafers berücksichtigt, um die Bearbeitung des Wafers mit der vorgesehenen Lagegenauigkeit durchführen zu können.

Als ein Beispiel einer Waferbearbeitung wird nun das Markieren bzw. das Beschreiben des Wafers mittels einem Laserstrahl in einer Markiervorrichtung erläutert, die die vorstehende Ausrichtvorrichtung der Erfindung verwendet und die genauer z.B. in der EP 1231627 A2 beschrieben wird, deren Inhalt hier durch Bezugnahme aufgenommen wird.

Die Markiervorrichtung hat im wesentlichen eine Lasereinrichtung, die einen Laserstrahl erzeugt, welcher über eine Laserstrahlablenkeinheit und eine Fokussiereinrichtung auf die Waferoberfläche gelenkt wird, um den Wafer an einer vorgesehenen Stelle zu markieren oder zu beschreiben. Als Laserstrahlablenkeinheit kann z.B. eine elektromotorisch angetriebene Galvanometerspiegeleinrichtung verwendet werden. Bei der Positionseinstellung der Laserstrahlablenkeinheit können nun der in der Ausrichtvorrichtung ermittelte Versatz oder die zugehörigen Versatzkoordinaten berücksichtigt werden, um einen Ausrichtfehler des Wafers auf dem Drehteller 1 der Ausrichtvorrichtung kompensieren zu können, wodurch eine hochgenaue Bearbeitung bzw. Markierung des Wafers ermöglicht wird.

Nach der Bearbeitung des Wafers durch die Bearbeitungsvorrichtung wird dann allgemein der bearbeitete Wafer von dem Roboterarm mit Endeffektor, der seitlich ansetzt, wieder vom Drehteller 1 hochgehoben und aus der Ausrichtvorrichtung entfernt und z.B. in einer Waferkassette abgelegt, um die Ausrichtvorrichtung wieder bereit für die Aufnahme und das Ausrichten eines weiteren Wafers zu machen.

In Alternative hierzu wird, wenn das Verfahren mit dem vorstehend erläuterten, zweiten, alternativen Schritt durchgeführt wird, d.h. die Hebeeinrichtung 5 direkt von dem Roboterarm mit dem Wafer beschickt wurde, nach der Bearbeitung des Wafers die Hebeeinrichtung 5 nach oben gefahren, wobei die Hebeeinrichtung den Wafer 10 vom Drehteller 1 aufnimmt. Nach Erreichen der Lade/Entladeposition der Hebeeinrichtung 5 wird diese in der Lade/Entlade-Position gestoppt und festgehalten, um ein Entladen des Wafers von der Hebeeinrichtung 5 mittels dem Endeffektor des Roboterarms durchführen zu könne. Die Hebeeinrichtung 5 (oder 5.1) kann nach dem Entladevorgang in der Lade/Entlade-Position verbleiben oder sie wird in ihre passive, untere Ruheposition abgesenkt.

## Patentansprüche

1. Vorrichtung zum Ausrichten eines Wafers (10), die einen Drehteller (1; 1.1) hat, der den Wafer (10) trägt und der um seine Drehachse (M) zum Ausrichten des Wafers (10) drehbar ist, **dadurch gekennzeichnet, dass** der Drehteller (1; 1.1) derart ausgebildet ist, dass der Wafer (10) auf dem Drehteller (1; 1.1) nur mit seinem Rand oder Randbereich aufliegt.

2. Vorrichtung nach Anspruch 1, **gekennzeichnet durch** eine Einrichtung zum Halten des Wafers (10) in einer Lage mit Abstand von dem Drehteller (1; 1.1) derart, dass sich der Drehteller (1; 1.1) ohne Wafer (10) drehen kann.

3. Vorrichtung nach Anspruch 2, **dadurch gekennzeichnet, dass** die Einrichtung eine Hebeeinrichtung (1; 1.1) zum Abheben oder Hochheben des Wafers (10) von dem Drehteller (1; 1.1), zum Halten des Wafers (10) in einer Lage mit Abstand von dem Drehteller und zum Absenken des Wafers (10) wieder auf den Drehteller (1; 1.1) ist.

4. Vorrichtung nach Anspruch 2 oder Anspruch 3, **dadurch gekennzeichnet, dass** die Einrichtung zum Halten des Wafers oder die Hebeeinrichtung (5; 5.1) geneigte oder konisch Auflagerflächen (55.1) hat, die alleine den Wafer(10) tragen und derart ausgebildet sind, dass der Wafer (10) nur mit seinem Rand oder mit seinem Randbereich auf ihnen aufliegt, wenn der Wafer (10) von der Einrichtung oder der Hebeeinrichtung (5; 5.1) getragen wird.

5. Vorrichtung nach einem der vorstehenden Ansprüche, **dadurch gekennzeichnet, dass** der Drehteller (1; 1.1) mindestens zwei sich gegenüberliegende, geneigte Flächen (20) aufweist, die zu einer Horizontalebene des Drehtellers (1; 1.1) hin derart geneigt sind, dass der Wafer (10) mit seinem Rand nur auf den geneigten Flächen (20) des Drehtellers (1; 1.1) aufliegt.

6. Vorrichtung nach Anspruch 5, **dadurch gekennzeichnet, dass** der Drehteller (1; 1.1) mehrere von einer Mitte des Drehtellers (1; 1.1) aus radial und eben sich erstreckende Stege (3; 3.3) hat, die als Ausleger mit jeweils einem auflagerlosen, freien Ende aufgebaut sind, und dass an den Enden der Stege (3; 3.3) jeweils ein Auflageteil (2; 2.2) mit einer geneigten Fläche (20) befestigt ist.

7. Vorrichtung nach einem der Ansprüche 5 bis 6, **dadurch gekennzeichnet, dass** die geneigte Fläche (20) in unterschiedliche Teilflächen (21, 22) mit jeweils unterschiedlichen Neigungen unterteilt ist.

8. Vorrichtung nach einem der vorstehenden Ansprüche, **gekennzeichnet durch** eine Detektionseinrichtung (6) zum Erkennen einer Kerbe (90) oder einer Markierung des Wafers (10).

9. Vorrichtung nach einem der vorstehenden Ansprüche, **gekennzeichnet durch** eine Wegmesseinrichtung oder eine Drehwinkelmesseinrichtung zum ständigen Ermitteln und Verfolgen eines Wegs oder eines Drehwinkels des Drehtellers (1; 1.1).

10. Vorrichtung nach einem der vorstehenden Ansprüche, **gekennzeichnet durch** eine Detektionseinrichtung (8.3) zum Detektieren, ob sich ein Endeffektor eines Roboterarms zum Laden oder Entladen der Ausrichtvorrichtung mit einem Wafer im Störkreis oder Drehkreis des Drehtellers 1 befindet.

11. Vorrichtung nach einem der vorstehenden Ansprüche, **gekennzeichnet durch** eine Detektionseinrichtung (8.4) zum Detektieren, ob sich ein Wafer (10) auf dem Drehteller (1) oder der Hebeeinrichtung (5) befindet.

12. Vorrichtung nach einem der vorstehenden Ansprüche, **gekennzeichnet durch** eine Drehteller-Detektionseinrichtung (8) zum Detektieren des Drehtellers (1; 1.1) in einer Drehtellerreferenzposition.

13. Verfahren zum Ausrichten eines Wafers (10), wobei ein Drehteller (1; 1.1) einer Ausrichtvorrichtung mit einem Wafer (10) derart beladen wird, dass der Wafer (10) nur mit seinem Rand auf dem Drehteller (1; 1.1) aufliegt.

14. Verfahren nach Anspruch 13, **dadurch gekennzeichnet, dass** der Drehteller (1, 1.1) über eine Einrichtung zum Halten eines Wafers oder eine Hebeeinrichtung (5; 5.1) der Ausrichtvorrichtung beladen oder entladen wird.

15. Verfahren nach Anspruch 13, **dadurch gekennzeichnet, dass** die Halteeinrichtung oder die Hebeeinrichtung direkt mit einem Wafer von einem Endeffektor eines Roboterarms beladen oder entladen wird.

16. Verfahren nach Anspruch 13, **dadurch gekennzeichnet, dass** der Drehteller (1; 1.1) der Ausrichtvorrichtung direkt von einem Endeffektor eines Roboterarms mit einem Wafer beladen oder entladen wird.

17. Verfahren nach einem der Ansprüche 13 bis 16, **dadurch gekennzeichnet, dass** vor dem Beladen des Drehtellers (1; 1.1) der unbeladene Drehteller (1; 1.1) der Ausrichtvorrichtung in Abhängigkeit von einem Detektionssignal von einer Drehteller-Detektionseinrichtung (8) der Ausrichtvorrichtung in eine Drehtellerreferenzposition gedreht wird und dass der Drehteller (1; 1.1) in der Drehtellerreferenzposition mit einem zu bearbeitenden Wafer (10) beladen wird.

18. Verfahren nach Anspruch 17, **dadurch gekennzeichnet, dass** der Drehteller (1; 1.1) nach dem Beladen mit einem Wafer (10) maximal einmal komplett um 360 ° gedreht wird, wobei die Drehung gestoppt wird, wenn eine Detektionseinrichtung (6) zum Detektieren einer randseitigen Kerbe (90) des Wafers (10) die Kerbe (90) detektiert und der Wafer (10) in seiner WaferReferenzposition ist oder wenn nach einer vollständigen Drehung des Drehtellers (1; 1.1) mit aufliegendem Wafer (10) keine Kerbe (90) detektiert worden ist.

19. Verfahren nach Anspruch 18, **dadurch gekennzeichnet, dass** nach der vollständigen Drehung um 360°, wenn von der Detektionseinrichtung (6) keine Kerbe (90) detektiert worden ist und der Drehteller (1; 1.1) wieder in seine Drehtellerrferenzposition erreicht hat, der Wafer (10) von dem Drehteller (1; 1.1) derart entfernt wird, dass der Drehteller (1; 1.1) ohne Wafer (10) gedreht werden kann, dass der Wafer (10) selbst nicht gedreht wird und dass der Wafer (10) beim Entfernen von dem Drehteller (1; 1.1) nur an seinem Rand berührt wird, dass der leere Drehteller (1; 1.1) dann derart gedreht wird, bevorzugt um 30 °, dass die Kerbe (90) des Wafers (10) detektierbar wird,
dass der Drehteller (1; 1.1) dann wieder mit dem Wafer (10) beladen wird, wobei wieder nur der Rand des Wafers berührt wird, und
dass dann der Drehteller (1; 1.1) mit dem Wafer gedreht wird, bis die Kerbe (90) des Wafers von der Detektionseinrichtung (6) detektiert wird und der Wafer (10) dann in der Waferreferenzposition ist.

20. Verfahren nach Anspruch 19, **dadurch gekennzeichnet, dass** beim Entfernen von dem Drehteller (1; 1.1) der Wafer (10) mittels einer Hebeeinrichtung (5; 5.1) der Ausrichtvorrichtung von dem Drehteller (1; 1.1) senkrecht nach oben abgehoben wird, wobei der Wafer (10) bei dieser Hubbewegung ausschließlich mit seinem Rand auf mindestens einer konischen oder geneigten Fläche (55.1) der Hebeeinrichtung (5; 5.1) aufliegt.

21. Verfahren nach Anspruch 20, **dadurch gekennzeichnet, dass** nach der Drehung des Drehtellers (1; 1.1) anschließend die Hebeeinrichtung (5; 5.1) wieder nach unten bewegt und der Wafer mit seinem Rand wieder auf geneigte Flächen (20) des Drehtellers (1; 1.1) abgesenkt wird.

22. Verfahren nach einem der Ansprüche 13 bis 21, **dadurch gekennzeichnet, dass**, nachdem der Wafer seine Waferreferenzposition erreicht hat, der Wafer (10) von dem Drehteller (1; 1.1) derart entfernt wird, dass der Drehteller (1; 1.1) ohne Wafer gedreht werden kann, dass der Wafer (10) selbst nicht gedreht wird und dass der Wafer beim Entfernen von dem Drehteller (1; 1.1) nur an seinem Rand berührt wird.

23. Verfahren nach Anspruch 22, **dadurch gekennzeichnet, dass** nach dem Entfernen des Wafers (10) von dem Drehteller (1; 1.1) der leere Drehteller (1; 1.1), der vier Stege (3) hat, wobei jeweils zwei benachbarte Stege um 90 ° auseinanderliegen, dann derart gedreht wird, dass die Kerbe (90) des Wafers (10) mittig zwischen zwei benachbarten Stegen (3.1, 3.2) angeordnet ist, und dass dann der Drehteller (1; 1.1) wieder mit dem Wafer (10) beladen wird.

24. Verfahren nach einem der Ansprüche 13 bis 23, **dadurch gekennzeichnet, dass** der Wafer (10) nach Erreichen seiner Waferreferenzposition in eine vorgegebene Bearbeitungsposition gedreht wird.

25. Vorrichtung nach einem der Ansprüche 13 bis 24, **dadurch gekennzeichnet, dass** der Drehwinkel oder Weg des Drehtellers (1; 1.1) ständig von einer Wegmesseinrichtung ermittelt wird.

## Geänderte Patentansprüche

### Geänderte Patentansprüche gemäss Regel 86(2) EPÜ.

**1.** Vorrichtung zum Ausrichten eines Wafers (10), die einen Drehteller (1; 1.1), der den Wafer (10) trägt und der um seine Drehachse (M) zum Ausrichten des Wafers (10) drehbar ist, und eine Einrichtung zum Halten des Wafers (10) in einer Lage mit Abstand von dem Drehteller (1; 1.1) derart hat, dass sich der Drehteller (1; 1.1) ohne Wafer (10) drehen kann;
**dadurch gekennzeichnet,**
**dass** der Drehteller (1; 1.1) mindestens zwei gegenüberliegende, geneigte Flächen (20) aufweist, die zu einer Horizontalebene des Drehtellers (1; 1.1) hin derart geneigt sind, dass sie den Wafer (10) nur an seinem Rand tragen; und
**dass** die Einrichtung zum Halten des Wafers geneigte oder konisch Auflagerflächen (55.1) hat, die den Wafer (10) nur an dessen Rand tragen, wenn die Einrichtung den Wafer trägt.

**2.** Vorrichtung nach Anspruch 1, **dadurch gekennzeichnet, dass** die Einrichtung eine Hebeeinrichtung (5; 5.1) zum Abheben oder Hochheben des Wafers (10) von dem Drehteller (1; 1.1), zum Halten des Wafers (10) in einer Lage mit Abstand von dem Drehteller und zum Absenken des Wafers (10) wieder auf den Drehteller (1; 1.1) ist.

**3.** Vorrichtung nach Anspruch 1 oder Anspruch 2, **dadurch gekennzeichnet, dass** der Drehteller (1; 1.1) mehrere von einer Mitte des Drehtellers (1; 1.1) aus radial und eben sich erstreckende Stege (3; 3.3) hat, die als Ausleger mit jeweils einem auflagerlosen, freien Ende aufgebaut sind, und dass an den Enden der Stege (3; 3.3) jeweils ein Auflageteil (2; 2.2) mit einer geneigten Fläche (20) befestigt ist.

**4.** Vorrichtung nach einem der vorstehenden Ansprüche, **dadurch gekennzeichnet, dass** jede geneigte Fläche (20) des Drehtellers (1; 1.1) und jede geneigte oder konisch Auflagerfläche (55.1) der Einrichtung zum Halten des Wafers unterschiedliche Teilflächen (21, 22, 23; 55.2, 55.3, 55.4) mit jeweils unterschiedlichen Neigungen hat.

**5.** Vorrichtung nach Anspruch 4, **dadurch gekennzeichnet, dass** die geneigte Fläche (20) eine obere, ebene Fläche (21), eine daran anschließende mittlere, steiler geneigte Fläche (23) und eine diese fortsetzende, untere, geneigte, ebene Fläche (22) aufweist, wobei die obere Fläche (21) eine mittlere Neigung, bevorzugt einen Neigungswinkel von etwa 45°, gegenüber einer horizontalen Ebene hat, die mittlere Fläche (23) steiler, bevorzugt etwa 70 °, als die obere Fläche (21) ist und die Funktion eines Anschlags für den Waferrand hat, wenn der Wafer seine waagrechte Lage auf den Auflageteilen (2; 2.2) des Drehtellers (1; 1.1) eingenommen hat, und die untere Fläche (22) eine geringere Neigung als die obere Fläche (21) und die mittlere Fläche (23), bevorzugt etwa 12,5°, gegenüber der horizontalen Ebene hat.

**6.** Vorrichtung nach Anspruch 4 oder Anspruch 5, **dadurch gekennzeichnet, dass** die geneigte Auflagerfläche (55.1) eine obere, abgerundete Fläche (55.4), eine daran anschließende, mittlere, geneigte Umfangsfläche (55.2), die bevorzugt einen Neigungswinkel von 70 ° zu einer horizontalen Ebene hat und als Anschlag für den Waferrand dient, wenn der Wafer 10 seine waagrechte Lage eingenommen hat, und eine daran anschließende, konisch abflachende Fläche (55.3) aufweist, die bevorzugt einen Neigungswinkel gegenüber der horizontalen Ebene von 10 ° hat.

**7.** Vorrichtung nach einem der vorstehenden Ansprüche, **dadurch gekennzeichnet, dass** der Drehteller aus Kohlefaserverbundwerkstoff gefertigt ist.

**8.** Vorrichtung nach einem der vorstehenden Ansprüche, **dadurch gekennzeichnet, dass** die Oberflächen des Drehtellers verschlossen sind.

**9.** Vorrichtung nach einem der vorstehenden Ansprüche, **gekennzeichnet durch** eine Detektionseinrichtung (6) zum Erkennen einer Kerbe (90) oder einer Markierung des Wafers (10) .

**10.** Vorrichtung nach einem der vorstehenden Ansprüche, **gekennzeichnet durch** eine Wegmesseinrichtung oder eine Drehwinkelmesseinrichtung zum ständigen Ermitteln und Verfolgen eines Wegs oder eines Drehwinkels des Drehtellers (1; 1.1).

**11.** Vorrichtung nach einem der vorstehenden Ansprüche, **gekennzeichnet durch** eine Detektionseinrichtung (8.3) zum Detektieren, ob sich ein Endeffektor eines Roboterarms zum Laden oder Entladen der Ausrichtvorrichtung mit einem Wafer im Störkreis oder Drehkreis des Drehtellers (1) befindet.

**12.** Vorrichtung nach einem der Ansprüche 2 bis 11, **gekennzeichnet durch** eine Detektionseinrichtung (8.4) zum Detektieren, ob sich ein Wafer (10) auf dem Drehteller (1) oder der Hebeeinrichtung (5) befindet.

**13.** Vorrichtung nach einem der vorstehenden Ansprüche, **gekennzeichnet durch** eine Drehteller-Detektionseinrichtung (8) zum Detektieren des Drehtellers (1; 1.1) in einer Drehtellerreferenzposition.

**14.** Verfahren zum Ausrichten eines Wafers (10), das die folgenden Schritte aufweist:
vor einem Beladen eines Drehtellers (1; 1.1) einer Ausrichtvorrichtung wird der unbeladene Drehteller (1; 1.1) in Abhängigkeit von einem Detektionssignal von einer Drehteller-Detektionseinrichtung (8) der Ausrichtvorrichtung in eine Drehtellerreferenzposition gedreht;
der Drehteller (1; 1.1) in der Drehtellerreferenzposition wird dann mit einem zu bearbeitenden Wafer (10) derart beladen, dass der Wafer (10) nur mit seinem Rand auf geneigten Flächen (20) des Drehtellers (1; 1.1) aufliegt;
nach dem Beladen mit einem Wafer (10) führt der Drehteller (1; 1.1) maximal eine vollständige Drehung aus, wobei der Drehteller gestoppt wird, wenn eine Detektionseinrichtung (6) zum Detektieren einer randseitigen Kerbe (90) des Wafers (10) die Kerbe (90) detektiert und der Wafer (10) in seiner Waferreferenzposition ist oder wenn nach der vollständigen Drehung des Drehtellers (1; 1.1) keine Kerbe (90) des Wafers (10) detektiert worden ist;
nach der vollständigen Drehung des Drehtellers, wenn von der Detektionseinrichtung (6) keine Kerbe (90) detektiert worden ist und der Drehteller (1; 1.1) wieder seine Drehtellerreferenzposition erreicht hat, wird der Wafer (10) von dem Drehteller (1; 1.1) dann derart entfernt, dass der Drehteller (1; 1.1) ohne Wafer (10) gedreht werden kann, dass der Wafer (10) selbst nicht gedreht wird und dass der Wafer (10) beim Entfernen von dem Drehteller (1; 1.1) nur an seinem Rand von geneigten Auflagerflächen der Ausrichtvorrichtung getragen wird, wobei der leere Drehteller (1; 1.1) dann derart gedreht wird, dass die Kerbe (90) des Wafers (10) detektierbar wird, wobei dann der Drehteller (1; 1.1) wieder mit dem Wafer (10) derart beladen wird, dass wieder nur der Rand des Wafers berührt wird, und wobei der Drehteller (1; 1.1) dann mit dem Wafer gedreht wird, bis die Kerbe (90) des Wafers von der Detektionseinrichtung (6) detektiert wird und die Drehung des Drehtellers mit dem Wafer (10) in der Waferreferenzposition gestoppt wird.

**15.** Verfahren nach Anspruch 14, **dadurch gekennzeichnet, dass** der Drehteller (1; 1.1) der Ausrichtvorrichtung direkt von einem Endeffektor eines Roboterarms mit einem Wafer beladen oder entladen wird.

**16.** Verfahren nach Anspruch 14, **dadurch gekennzeichnet, dass** der Drehteller (1, 1.1) über eine Einrichtung zum Halten eines Wafers oder eine Hebeeinrichtung (5; 5.1) der Ausrichtvorrichtung beladen oder entladen wird.

**17.** Verfahren nach Anspruch 14, **dadurch gekennzeichnet, dass** die Halteeinrichtung oder die Hebeeinrichtung direkt mit einem Wafer von einem Endeffektor eines Roboterarms beladen oder entladen wird.

**18.** Verfahren nach Anspruch 16 oder Anspruch 17, **dadurch gekennzeichnet, dass** beim Entfernen von dem Drehteller (1; 1.1) der Wafer (10) mittels einer Hebeeinrichtung (5; 5.1) der Ausrichtvorrichtung von dem Drehteller (1; 1.1) senkrecht nach oben abgehoben wird, wobei der Wafer (10) bei dieser Hubbewegung ausschließlich mit seinem Rand auf mindestens einer konischen oder geneigten Auflagerfläche (55.1) der Hebeeinrichtung (5; 5.1) aufliegt.

**19.** Verfahren nach Anspruch 18, **dadurch gekennzeichnet, dass** nach der Drehung des Drehtellers (1; 1.1) anschließend die Hebeeinrichtung (5; 5.1) wieder nach unten bewegt und der Wafer mit seinem Rand wieder auf die geneigten Flächen (20) des Drehtellers (1; 1.1) abgesenkt wird.

**20.** Verfahren nach einem der Ansprüche 14 bis 19, **dadurch gekennzeichnet, dass**, nachdem der Wafer seine Waferreferenzposition erreicht hat, der Wafer (10) von dem Drehteller (1; 1.1) mittels der Einrichtung derart entfernt wird, dass der Drehteller (1; 1.1) ohne Wafer gedreht werden kann, dass der Wafer (10) selbst nicht gedreht wird und dass der Wafer beim Entfernen von dem Drehteller (1; 1.1) nur mit den geneigten Auflagerflächen (55.1) nur an seinem Rand getragen wird.

**21.** Verfahren nach Anspruch 20, **dadurch gekennzeichnet, dass** nach dem Entfernen des Wafers (10) von dem Drehteller (1; 1.1) der leere Drehteller (1; 1.1), der bevorzugt vier Stege (3) hat; wobei jeweils zwei benachbarte Stege um 90 ° auseinanderliegen, dann derart gedreht wird, dass die Kerbe (90) des Wafers (10) mittig zwischen zwei benachbarten Stegen (3.1, 3.2) angeordnet ist, und dass dann der Drehteller (1; 1.1) wieder mit dem Wafer (10) von der Einrichtung beladen wird.

**22.** Verfahren nach einem der Ansprüche 14 bis 21, **dadurch gekennzeichnet, dass** der Wafer (10) nach Erreichen seiner Waferreferenzposition in eine vorgegebene Bearbeitungsposition gedreht wird.

**23.** Verfahren nach einem der Ansprüche 14 bis 22, **dadurch gekennzeichnet, dass** der Drehwinkel oder Weg des Drehtellers (1; 1.1) ständig von einer Wegmesseinrichtung ermittelt wird.
